# EUROPEAN PATENT APPLICATION

(11) **EP 4 496 445 A1**
(43) Date of publication of application: **22.01.2025**
(21) Application number: 24728008.4
(22) Date of filing: 16.05.2024
(51) Int. Cl.: H05K 7/20, H04M 1/02, H01L 23/373

(54) **ELECTRONIC DEVICE COMPRISING HEAT DISSIPATION STRUCTURE**

(30) Priority: 01.06.2023 KR 20230071137; 14.07.2023 KR 20230091561
(71) Applicant: Samsung Electronics Co., Ltd, Suwon-si, Gyeonggi-do 16677 (KR)
(72) Inventor: AHN, Joseph, Suwon-si, Gyeonggi-do 16677 (KR); LEE, Youngchul, Suwon-si, Gyeonggi-do 16677 (KR); KIM, Taehyeong, Suwon-si, Gyeonggi-do 16677 (KR); KIM, Bonghwan, Suwon-si, Gyeonggi-do 16677 (KR); PARK, Min, Suwon-si, Gyeonggi-do 16677 (KR); PARK, Jongkil, Suwon-si, Gyeonggi-do 16677 (KR); YUN, Hajoong, Suwon-si, Gyeonggi-do 16677 (KR); JEONG, Hui, Suwon-si, Gyeonggi-do 16677 (KR)
(74) Representative: HGF
(86) International application number: PCT/KR2024/006664
(87) International publication number: WO 2024/248372

(57) **Abstract**

An electronic device according to an embodiment of the disclosure comprises a housing including a first surface and a second surface facing in a direction opposite to the first surface, a supporting member accommodated in the housing between the first surface and the second surface, the supporting member including an accommodating recess or an accommodating hole formed to a first depth from one of two opposite surfaces and a seating recess provided in at least a portion of a circumference of the accommodating recess or the accommodating hole in any one surface of the supporting member, and a heat dissipation member including a chamber portion at least partially accommodated in the accommodating recess or the accommodating hole and at least one flange portion extending from at least a portion of an edge of the chamber portion and welded to a bottom surface of the seating recess. The seating recess is recessed to a second depth smaller than the first depth from any one surface of the supporting member. Other various embodiments are possible.

## Description

### [Technical Field]

Embodiment(s) of the disclosure relate to electronic devices, e.g., electronic devices including a heat dissipation structure for moving, dispersing and/or dissipating heat generated internally.

### [Background Art]

Generally, the electronic device means a device performing a particular function according to its equipped program, and may comprise devices such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated and high-speed, high-volume wireless communication becomes commonplace, mobile communication terminals are recently being equipped with various functions. For example, an electronic device comes with the integrated functionality, including an entertainment function, such as playing video games, a multimedia function, such as replaying music/videos, a communication and security function for mobile banking, and a scheduling or e-wallet function.

As the performance of electrical elements equipped with processors or communication modules, such as integrated circuit chips, enhances dramatically, an environment in which these various functions may be integrated into one electronic device is provided. Enhancement in the performance of electrical elements not only provides an environment in which various functions may be mounted on a single electronic device, but also enhance data communication and processing speeds.

The above-described information may be provided as related art for the purpose of helping understanding of the disclosure. No claim or determination is made as to whether any of the foregoing is applicable as prior art in relation to the disclosure.

### [Technical Problem]

Heat generated from electrical element(s), such as integrated circuit chips, may impair the operating environment of electronic devices. As the performance of various electrical elements enhances and the degree of integration of electronic devices increases, and/or the capacity of image or sound data increases, deterioration of the operating environment due to heat generation may increase. Integrated circuit chips equipped with circuit devices, such as processors, may generate more heat than other electrical elements. When more heat is generated in a small area and/or when the generated heat accumulates inside the electronic device, the operating environment of the electrical element(s) may become worse.

In order to prevent overheating, it is advantageous to release, or dissipate, the generated heat from these components. To this end, electronic devices, such as discussed above, comprise heat dissipation components, for example, such as a vapor chamber. In some examples, the inclusion of heat dissipation components (e.g. larger heat dissipation components) may need to be considered with regard to structural limitations of the arrangement electronic devices discussed above, such that the heat dissipation components are secured, and dissipate heat efficiently.

### [Disclosure of Invention]

### [Solution to Problems]

Examples of the present disclosure may address, solve and/or mitigate the problems and or disadvantages described above.

Examples of the disclosure aim to address the foregoing issues and/or drawbacks and provide advantages described below, providing an electronic device including a heat dissipation structure for moving, dispersing, or dissipating internally generated heat.

Examples of the disclosure may provide an electronic device including a heat dissipation structure that creates a good operating environment by moving, dispersing, or dissipating heat generated in a narrow area.

An electronic device according to an embodiment of the disclosure comprises a housing including a first surface and a second surface facing in a direction opposite to the first surface, a supporting member accommodated in the housing between the first surface and the second surface, the supporting member including an accommodating recess or an accommodating hole formed to a first depth from one of two opposite surfaces and a seating recess provided in at least a portion of a circumference of the accommodating recess or the accommodating hole in any one surface of the supporting member, and a heat dissipation member including a chamber portion at least partially accommodated in the accommodating recess or the accommodating hole and at least one flange portion extending from at least a portion of an edge of the chamber portion and welded to a bottom surface of the seating recess. In an embodiment, the seating recess is recessed to a second depth smaller than the first depth from any one surface of the supporting member.

According to an embodiment of the disclosure, an electronic device comprises a housing, a supporting member accommodated in the housing, the supporting member including an accommodating recess or an accommodating hole provided in at least one surface and a seating recess provided in at least a portion of a circumference of the accommodating recess or the accommodating hole in any one surface of the supporting member, a heat dissipation member including a chamber portion at least partially accommodated in the accommodating recess or the accommodating hole and at least one flange portion extending from at least a portion of an edge of the chamber portion and welded to a bottom surface of the seating recess, and a plurality of welding marks formed on the flange portion and arranged in at least one row along a circumference of the chamber portion. In an embodiment, the welding marks have a circular or polygonal shape with a diameter or a diagonal length of 0.2mm or more and 0.4mm or less. In an embodiment, a gap between two adjacent welding marks of the welding marks may be 0.045mm or more and 0.155mm or less.

However, examples of the disclosure are not limited to the foregoing, and other unmentioned objects would be apparent to one of ordinary skill in the art from the following description.

### [Brief Description of Drawings]

The foregoing and other aspects, configurations, and/or advantages of an embodiment of the disclosure will be more apparent from the following detailed description taken in conjunction with the accompanying drawings.
FIG. 1 is a block diagram illustrating an electronic device in a network environment according to an embodiment of the disclosure;
FIG. 2 is a front perspective view illustrating an electronic device according to an embodiment of the disclosure;
FIG. 3 is a perspective view illustrating a rear surface of the electronic device of FIG. 2 according to an embodiment of the disclosure;
FIG. 4 is an exploded front perspective view illustrating an electronic device according to an embodiment of the disclosure;
FIG. 5 is a rear exploded perspective view illustrating an electronic device according to an embodiment of the disclosure;
FIG. 6 is a view illustrating a heat dissipation structure of an electronic device according to an embodiment of the disclosure;
FIG. 7 is a view illustrating a heat dissipation structure of an electronic device, cut along line A-A' of FIG. 6 according to an embodiment of the disclosure;
FIG. 8 is a view illustrating a rear surface of a heat dissipation structure of an electronic device according to an embodiment of the disclosure;
FIG. 9 is a view illustrating a front surface of a heat dissipation structure of an electronic device according to an embodiment of the disclosure;
FIG. 10 is a cross-sectional view illustrating a heat dissipation member of a heat dissipation structure, taken along line C-C' of FIG. 9 according to an embodiment of the disclosure;
FIG. 11 is a view illustrating a welding trajectory or welding mark(s) for a heat dissipation member according to an embodiment of the disclosure;
FIG. 12 is a view illustrating a heat dissipation structure of an electronic device according to an embodiment of the disclosure;
FIG. 13 is a view illustrating a heat dissipation structure of an electronic device, cut along line B-B' of FIG. 12 according to an embodiment of the disclosure;
FIG. 14 is a view illustrating a reinforcing structure of a supporting member in a heat dissipation structure according to an embodiment of the disclosure;
FIG. 15 is a view illustrating a reinforcing structure of a supporting member in a heat dissipation structure according to an embodiment of the disclosure; and
FIG. 16 is a view illustrating a front surface of a heat dissipation structure of an electronic device according to an embodiment of the disclosure.

Throughout the drawings, like reference numerals may be assigned to like parts, components, and/or structures.

### [Mode for the Invention]

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

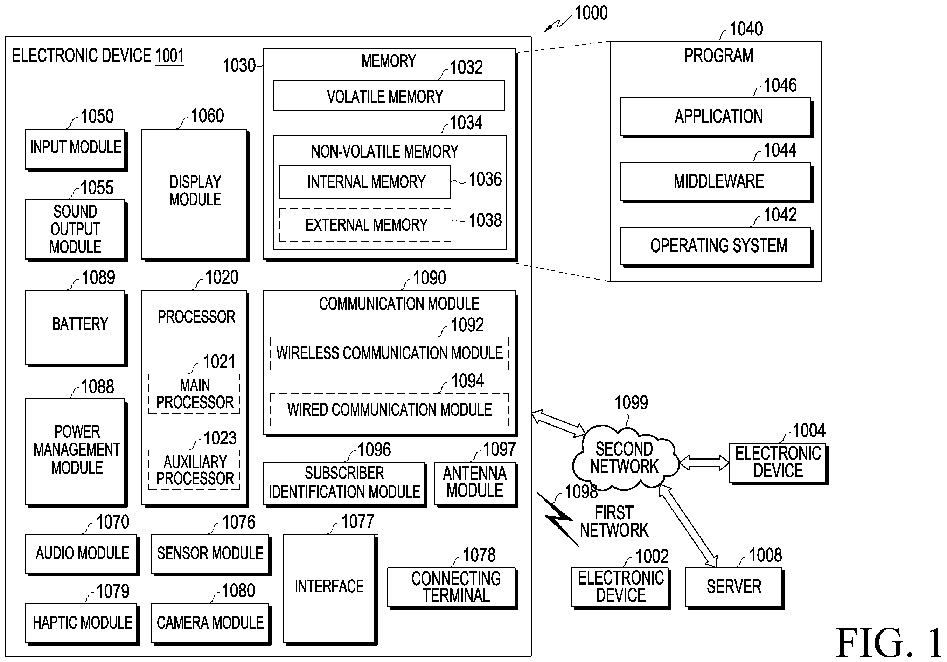

FIG. 1 is a block diagram illustrating an electronic device 1001 in a network environment 1000 according to an embodiment of the disclosure. Referring to FIG. 1, the electronic device 1001 in the network environment 1000 may communicate with at least one of an electronic device 1002 via a first network 1098 (e.g., a short-range wireless communication network), or an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module (SIM) 1096, or an antenna module 1097. In an embodiment, at least one (e.g., the connecting terminal 1078) of the components may be omitted from the electronic device 1001, or one or more other components may be added in the electronic device 101. According to an embodiment, some (e.g., the sensor module 1076, the camera module 1080, or the antenna module 1097) of the components may be integrated into a single component (e.g., the display module 1060).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 1001 includes the main processor 1021 and the auxiliary processor 1023, the auxiliary processor 1023 may be configured to use lower power than the main processor 1021 or to be specified for a designated function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 123. According to an embodiment, the auxiliary processor 1023 (e.g., the neural processing unit) may include a hardware structure specified for artificial intelligence model processing. The artificial intelligence model may be generated via machine learning. Such learning may be performed, e.g., by the electronic device 1001 where the artificial intelligence is performed or via a separate server (e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by other component (e.g., the processor 1020) of the electronic device 1001, from the outside (e.g., a user) of the electronic device 1001. The input module 1050 may include, for example, a microphone, a mouse, a keyboard, keys (e.g., buttons), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display 1060 may include, for example, a display, a hologram device, or a projector and control circuitry to control a corresponding one of the display, hologram device, and projector. According to an embodiment, the display 1060 may include a touch sensor configured to detect a touch, or a pressure sensor configured to measure the intensity of a force generated by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., the electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 101, and then generate an electrical signal or data value corresponding to the detected state. According to an embodiment, the sensor module 1076 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or motion) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to an embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via a first network 1098 (e.g., a short-range communication network, such as Bluetooth^{™}, wireless-fidelity (Wi-Fi) direct, or infrared data association (IrDA)) or a second network 1099 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 1092 may identify or authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 1097 may include a plurality of antennas (e.g., an antenna array). In this case, at least one antenna appropriate for a communication scheme used in a communication network, such as the first network 1098 or the second network 1099, may be selected from the plurality of antennas by, e.g., the communication module 1090. The signal or the power may then be transmitted or received between the communication module 1090 and the external electronic device via the selected at least one antenna. According to an embodiment, other parts (e.g., radio frequency integrated circuit (RFIC)) than the radiator may be further formed as part of the antenna module 1097.

According to an embodiment, the antenna module 1097 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 1001 and the external electronic device 1004 via the server 1008 coupled with the second network 1099. The external electronic devices 1002 or 1004 each may be a device of the same or a different type from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In an embodiment, the external electronic device 1004 may include an internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or healthcare) based on 5G communication technology or IoT-related technology.

The electronic device according to embodiment(s) of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment(s) of the disclosure and terms used therein are not intended to limit the technical features described in the disclosure to specific embodiments, and should be understood to include various modifications, equivalents, or substitutes of the embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities. Some of the plurality of entities may be separately disposed in different components. According to embodiments, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

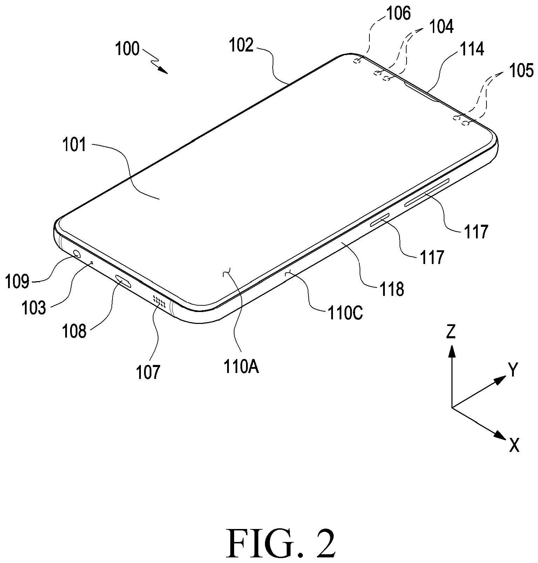

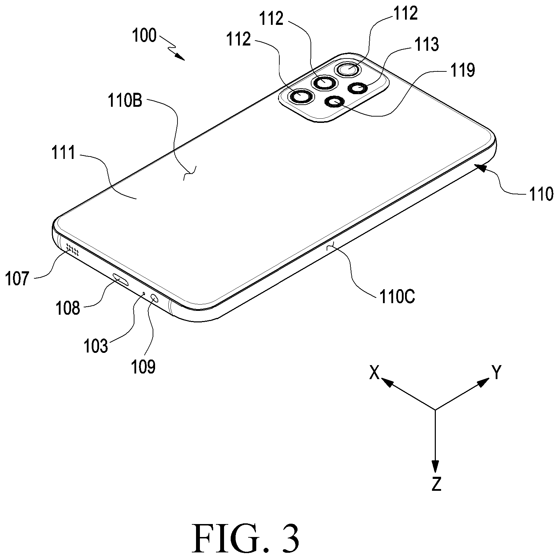

FIG. 2 is a front perspective view illustrating an electronic device 100 according to an embodiment of the disclosure. FIG. 3 is a perspective view illustrating a rear surface of the electronic device 100 of FIG. 2 according to an embodiment of the disclosure.

Referring to FIGS. 2 and 3, according to an embodiment, an electronic device 100 (e.g., the electronic device 1001 of FIG. 1) may include a housing 110 including a first surface (or front surface) 110A, a second surface (or rear surface) 110B, and a side surface 110C surrounding a space between the first surface 110A and the second surface 110B. According to an embodiment (not shown), the housing 110 may denote a structure forming the first surface 110A of FIG. 2, the second surface 110B of FIG. 3, and some of the side surfaces 110C. According to an embodiment, at least part of the first surface 110A may have a substantially transparent front plate 102 (e.g., a glass plate or polymer plate including various coat layers). The second surface 110B may be formed of a substantially opaque rear plate 111. The rear plate 111 may be formed of, e.g., laminated or colored glass, ceramic, polymer, metal (e.g., aluminum, stainless steel (STS), or magnesium), or a combination of at least two thereof. The side surface 110C may be formed by a side structure (or a "side bezel structure") 118 that couples to the front plate 102 and the rear plate 111 and includes a metal and/or polymer. In an embodiment, the rear plate 111 and the side structure 118 may be integrally formed together and include the same material (e.g., a metal, such as aluminum).

Although not shown, the front plate 102 may include area(s) that bend from at least a portion of an edge toward the rear plate 111 and seamlessly extend. In an embodiment, only one of the areas of the front plate 102 (or the rear plate 111), which bend to the rear plate 111 (or front plate 102) and extend may be included in one edge of the first surface 110A. According to an embodiment, the front plate 102 or the rear plate 111 may have a substantially flat plate shape. For example, no bent and extended area may be included. When an area bending and extending is included, the thickness of the electronic device 100 at the portion including the area bending and extending may be smaller than the thickness of the rest.

According to an embodiment, the electronic device 100 may include at least one of a display 101, an audio module (e.g., the microphone hole 103, the external speaker hole 107, and the phone receiver hole 114), a sensor module (e.g., the first sensor module 104, the second sensor module (not illustrated), or the third sensor module 119), a camera module (e.g., the first camera device 105, the second camera device 112, or the flash 113), a key input device 117, a light emitting device 106, and a connector hole (e.g., the first connector hole 108 or the second connector hole 109). In an embodiment, the electronic device 100 may exclude at least one (e.g., the key input device 117 or the light emitting device 106) of the components or may add other components.

The display 101 may output a screen or be visually exposed through a significant portion of the first surface 110A (e.g., the front plate 102), for example. In an embodiment, at least a portion of the display 101 may be visually exposed through the front plate 102 forming the first surface 110A, or through a portion of the side surface 110C. In an embodiment, the edge of the display 101 may be formed to be substantially the same in shape as an adjacent outer edge of the front plate 102. In an embodiment (not shown), the interval between the outer edge of the display 101 and the outer edge of the front plate 102 may remain substantially even to give a larger area of visual exposure of the display 101.

In an embodiment (not shown), a recess or an opening may be formed in a portion of the screen display area of the display 101, and there may be included at least one of an audio module (e.g., the phone receiver hole 114), a sensor module (e.g., the first sensor module 104), a camera module (e.g., the first camera device 105), and a light emitting device 106 that are aligned with the recess or the opening. In an embodiment (not shown), at least one of the audio module (e.g., the phone receiver hole 114), sensor module (e.g., the first sensor module 104), camera module (e.g., the first camera device 105), fingerprint sensor (not shown), and light emitting device 106 may be included on the rear surface of the screen display area of the display 101. In an embodiment (not shown), the display 101 may be disposed to be coupled with, or adjacent, a touch detecting circuit, a pressure sensor capable of measuring the strength (pressure) of touches, and/or a digitizer for detecting a magnetic field-type stylus pen. In an embodiment, when the front plate 102 or the rear plate 111 includes a bent and extended area(s), at least some of the sensor modules (e.g., the first sensor module 104 and the third sensor module 119) and/or at least some of the key input devices 117 may be disposed in the bent and extended area(s).

The audio modules 103, 107, and 114 may include a microphone hole 103 and speaker holes (e.g., the external speaker hole 107 and the phone receiver hole 114). A microphone for acquiring external sounds may be disposed in the microphone hole 103. In an embodiment, a plurality of microphones may be disposed to detect the direction of the sound. The speaker holes may include an external speaker hole 107 and a phone receiver hole 114. According to an embodiment, the speaker holes (e.g., the external speaker hole 107 and the phone receiver hole 114) and the microphone hole 103 may be implemented as a single hole, or speakers may be included without the speaker holes (e.g., the external speaker hole 107 and the phone receiver hole 114) (e.g., piezo speakers).

The sensor module may generate an electrical signal or data value corresponding to an internal operating state or external environmental state of the electronic device 100. The sensor modules may include a first sensor module 104 (e.g., a proximity sensor) and/or a second sensor module (not shown) (e.g., a fingerprint sensor) disposed on the first surface 110A of the housing 110 and/or a third sensor module 119 disposed on the second surface 110B of the housing 110. The second sensor module (not shown) (e.g., a fingerprint sensor) may be disposed on the second surface 110B or side surface 110C as well as the first surface 110A (e.g., the display 101) of the housing 110. The electronic device 100 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules may include a first camera device 105 disposed on the first surface 110A of the electronic device 100, and a second camera device 112 and/or a flash 113 disposed on the second surface 110B. The camera devices (e.g., the first camera device 105 and the second camera device 112) may include one or more lenses, an image sensor, and/or an image signal processor. The flash 113 may include, e.g., a light emitting diode (LED) or a xenon lamp. In an embodiment, one or more lenses (an infrared (IR) camera, a wide-angle lens, and a telephoto lens) and image sensors may be disposed on one surface of the electronic device 100. In an embodiment, flash 113 may emit infrared light. The infrared light emitted by the flash 113 and reflected by the subject may be received through the third sensor module 119. The electronic device 100 or the processor (e.g., the processor 1020 of FIG. 1) of the electronic device 100 may detect depth information about the subject based on the time point when the infrared light is received from the third sensor module 119.

The key input device 117 may be disposed on the side surface 110C of the housing 110. In an embodiment, the electronic device 100 may exclude all or some of the above-mentioned key input devices 117 and the excluded key input devices 117 may be implemented in other forms, e.g., as soft keys, on the display 101. In an embodiment, the key input device may include the sensor module disposed on the second surface 110B of the housing 110.

The light emitting device 106 may be disposed on, e.g., the first surface 110A of the housing 110. The light emitting device 106 may provide, e.g., information about the state of the electronic device 100 in the form of light. In an embodiment, the light emitting device 106 may provide a light source that interacts with, e.g., the camera module (e.g., the first camera device 105). The light emitting device 106 may include, e.g., a light emitting diode (LED), an infrared (IR) LED, or a xenon lamp.

The connector holes (e.g., the first connector hole 108 or the second connector hole 109) may include, e.g., a first connector hole 108 for receiving a connector (e.g., a USB connector) for transmitting/receiving power and/or data to/from an external electronic device (e.g., the electronic device 1002 of FIG. 1) and/or a second connector hole 109 (e.g., an earphone jack) for receiving a connector for transmitting/receiving audio signals to/from the external electronic device.

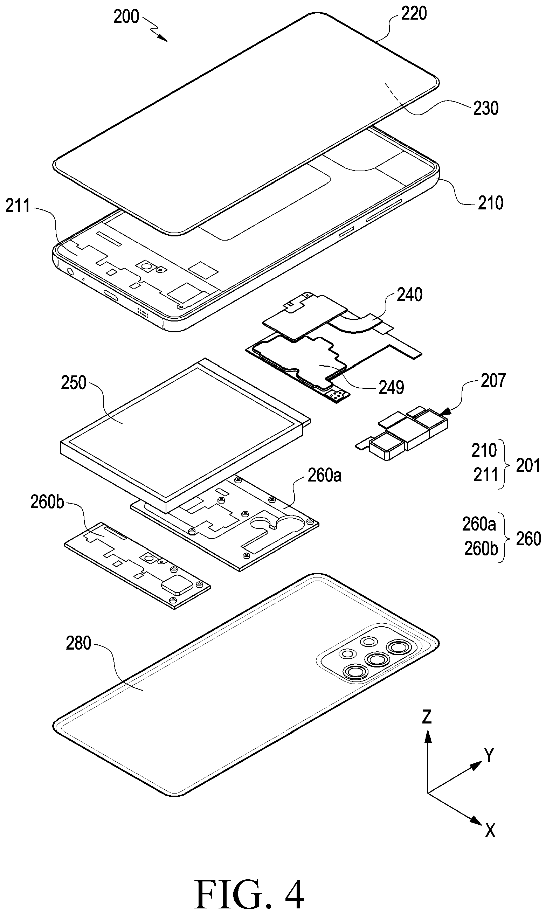

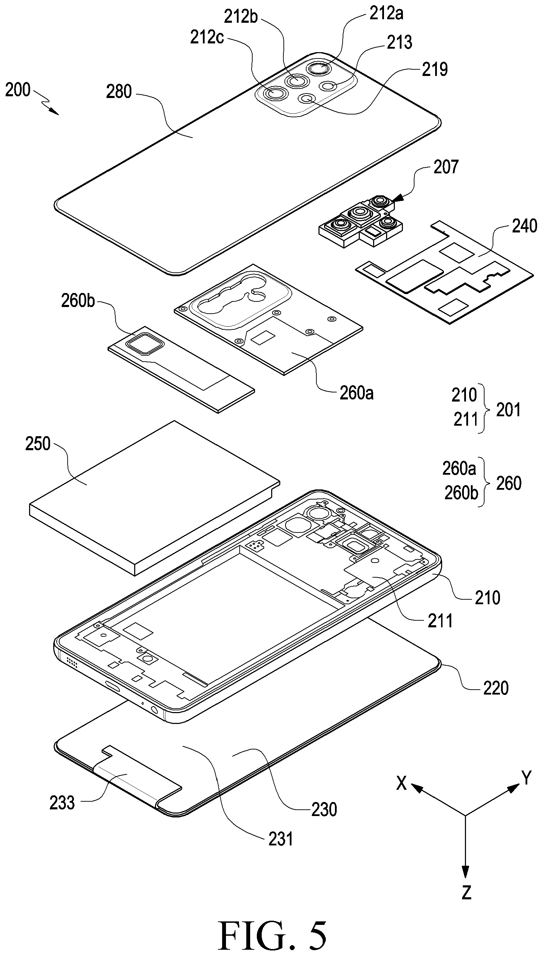

FIG. 4 is an exploded front perspective view illustrating an electronic device 200 (e.g., the electronic device 100 of FIG. 2), according to an embodiment of the disclosure. FIG. 5 is a rear exploded perspective view illustrating an electronic device 200 (e.g., the electronic device 100 of FIG. 2) according to an embodiment of the disclosure.

Referring to FIGS. 4 and 5, an electronic device 200 (e.g., the electronic device 1001, 1002, 1004, or 100 of FIG. 1, 2, or 3) may include a side structure 210, a first supporting member 211 (e.g., a bracket), a front plate 220 (e.g., the front plate 102 of FIG. 1), a display 230 (e.g., the display 101 of FIG. 1), a printed circuit board (or a board assembly) 240, a battery 250, a second supporting member 260 (e.g., a rear case), an antenna (not shown) (e.g., the antenna module 1097 of FIG. 1), a camera assembly 207, and a rear plate 280 (e.g., the rear plate 111 of FIG. 3). In an embodiment, the electronic device 200 may exclude at least one (e.g., the first supporting member 211 or the second supporting member 260) of the components or may add other components. At least one of the components of the electronic device 200 may be the same or similar to at least one of the components of the electronic device 100 of FIG. 2 or 3 and no duplicate description is made below.

The first supporting member 211 may be disposed inside the electronic device 200 to be connected with the side surface structure 210 or integrated with the side surface structure 210. The first supporting member 211 may be formed of, e.g., a metal and/or non-metallic material (e.g., polymer). When at least partially formed of a metallic material, a portion of the side structure 210 or the first supporting member 211 may function as an antenna. The display 230 may be joined onto one surface of the first supporting member 211, and the printed circuit board 240 may be joined onto the opposite surface of the first supporting member 211. A processor (e.g., the processor 1020 of FIG. 1), a memory (e.g., the memory 1030 of FIG. 1), and/or an interface (e.g., the interface 1077 of FIG. 1) may be mounted on the printed circuit board 240. The processor may include one or more of, e.g., a central processing unit, an application processor, a graphic processing device, an image signal processing, a sensor hub processor, or a communication processor. In an embodiment, processor and/or memory may refer to one of the circuit devices mounted in an integrated circuit chip.

According to an embodiment, the first supporting member 211 and the side structure 210 may be collectively referred to as a front case or a housing 201. According to an embodiment, the housing 201 may be generally understood as a structure for receiving, protecting, or disposing the printed circuit board 240 or the battery 250. In an embodiment, the housing 201 may be understood as including a structure that the user may visually or tangibly recognize from the exterior of the electronic device 200, e.g., the side structure 210, the front plate 220, and/or the rear plate 280. In an embodiment, the 'front or rear surface of the housing 201' may refer to the first surface 110A of FIG. 2 or the second surface 110B of FIG. 3. In an embodiment, the first supporting member 211 may be disposed between the front plate 220 (e.g., the first surface 110A of FIG. 2) and the rear plate 280 (e.g., the second surface 110B of FIG. 3) and may function as a structure for placing an electrical/electronic component, such as the printed circuit board 240 or the camera assembly 207.

The display 230 may include a display panel 231 and a flexible printed circuit board 233 extending from the display panel 231. It may be understood that the flexible printed circuit board 233 is, e.g., electrically connected to the display panel 231 while at least partially disposed on the rear surface of the display panel 231. In an embodiment, reference number '231' may be understood as a protective sheet disposed on the rear surface of the display panel. For example, the protective sheet may be understood as a portion of the display panel 231 unless otherwise designated in the detailed description below. In an embodiment, the protective sheet may function as a cushioning structure that absorbs external force (e.g., a low-density elastic material, such as a sponge) or an electromagnetic shielding structure (e.g., a copper sheet (CU sheet)). According to an embodiment, the display 230 may be disposed on the inner surface of the front plate 220 and, by including a light emitting layer, output a screen through at least a portion of the front plate 220 or the first surface 110A of FIG. 2. As mentioned above, the display 230 may output substantially the entire area of the front plate 220 or the first surface 110A of FIG. 2.

The memory may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 200 with an external electronic device and may include a USB connector, an SD card/multimedia card (MMC) connector, or an audio connector.

The second supporting member 260 may include, e.g., an upper supporting member 260a and a lower supporting member 260b. In an embodiment, the upper supporting member 260a, together with a portion of the first supporting member 211, may be disposed to surround the printed circuit board 240. For example, the printed circuit board 240 may be substantially disposed between the first supporting member 211 and the second supporting member 260 (e.g., upper supporting member 260a). A circuit device (e.g., a processor, a communication module, or a memory) implemented in the form of an integrated circuit chip or various electrical/electronic components may be disposed on the printed circuit board 240. According to an embodiment, the printed circuit board 240 may receive an electromagnetic shielding environment from the upper supporting member 260a. In an embodiment, at least one shield can 249 may be disposed on the printed circuit board 240. For example, the shield can 249 may provide an electromagnetic shielding environment to some areas or spaces on the printed circuit board 240. In an embodiment, the shield can 249 may be disposed to surround at least a portion of an integrated circuit chip where a processor, memory, and/or communication module is mounted.

According to an embodiment, the lower supporting member 260b may be utilized as a structure in which electrical/electronic components, such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). For example, the lower supporting member 260b, together with the other part of the first supporting member 211, may be disposed to surround the additional printed circuit board. A speaker module or interface disposed on an additional printed circuit board (not shown) or lower supporting member 260b may be disposed corresponding to the connector hole (e.g., the first connector hole 108 or the second connector hole 109) or the audio module (e.g., the microphone hole 103 or the speaker hole (e.g., the external speaker hole 107 or the phone receiver hole 114)) of FIG. 2.

The battery 250 may be a device for supplying power to at least one component of the electronic device 200. The battery 450 may include, e.g., a primary cell which is not rechargeable, a secondary cell which is rechargeable, or a fuel cell. At least a portion of the battery 250 may be disposed on substantially the same plane as the printed circuit board 240. The battery 250 may be integrally or detachably disposed inside the electronic device 200.

Although not shown, the antenna may include a conductor pattern implemented on the surface of the first supporting member 211 and/or the surface of the second supporting member 260 through, e.g., laser direct structuring (LDS). In an embodiment, the antenna may include a printed circuit pattern formed on the surface of the thin film. The thin film-type antenna may be disposed between the rear plate 280 and the battery 250. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 210 and/or the first supporting member 211.

The camera assembly 207 may include at least one camera module. Inside the electronic device 200, the camera assembly 207 may receive at least a portion of the light incident through the optical hole or the camera windows 212a, 212b, 212c, 213, and 219. In an embodiment, the camera assembly 207 may be disposed on the first supporting member 211 in a position adjacent to the printed circuit board 240. In an embodiment, the camera module(s) of the camera assembly 207 may be generally aligned with either one of the camera windows 212a, 212b, 212c, 213, and 219 and be a least partially surrounded by the second supporting member 260 (e.g., the upper supporting member 260a).

The following embodiments may be described with reference to the above-described configurations of the electronic devices 1001, 1002, 1004, 100, and 200. Even when not directly mentioned, any of the above-described configurations, and components described therein, of the embodiments may likewise apply to the following embodiments. It is noted that the orthogonal coordinate system referred to in the foregoing and/or following embodiments is exemplified for brevity of description, and the embodiment(s) of the disclosure are not limited thereto. For example, the orthogonal coordinate system mentioned in the disclosure may be differently defined depending on the type (e.g., bar type, foldable type, rollable type, and/or slidable type) of the electronic device to be actually manufactured, the user's use habit, and/or the orientation of the electronic device. In the illustrated embodiment, X-axis direction may refer to the width direction of the electronic device, and Y-axis direction may refer to the length direction of the electronic device. And/or Z-axis direction may refer to the thickness direction of the electronic device. In an embodiment described below, when an integrated circuit chip generates heat, the heat may move to the heat dissipation member through a thermal interface material, and the direction of heat movement may be understood to be substantially parallel to the Z-axis direction.

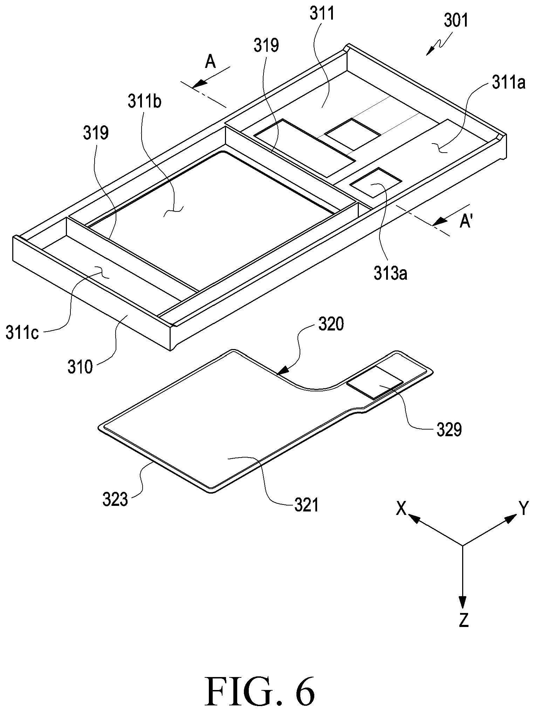

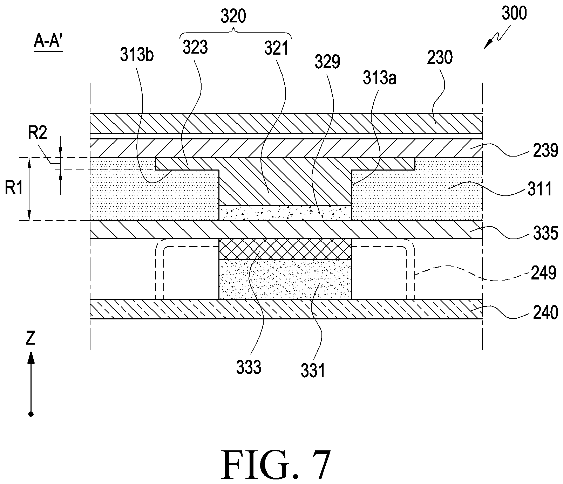

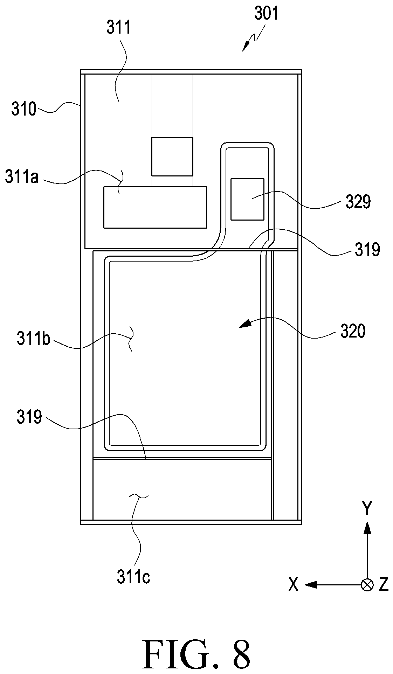

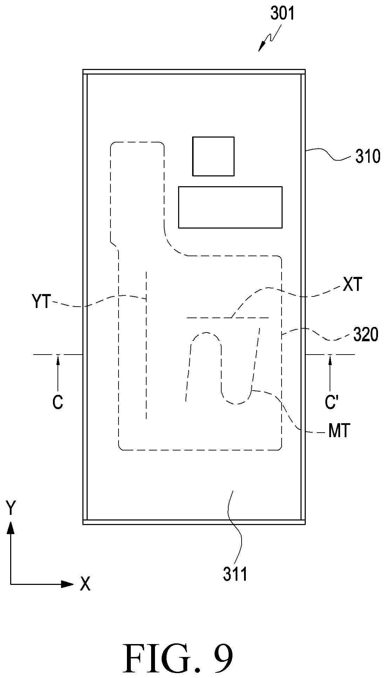

FIG. 6 is a view illustrating a heat dissipation structure 301 of an electronic device (e.g., the electronic device 1001, 1002, 1004, 100, or 200 of FIGS. 1 to 5) according to an embodiment of the disclosure. FIG. 7 is a view illustrating a heat dissipation structure 301 of an electronic device 300, cut along line A-A' of FIG. 6 according to an embodiment of the disclosure. FIG. 8 is a view illustrating a rear surface of a heat dissipation structure 301 of an electronic device 300 according to an embodiment of the disclosure. FIG. 9 is a view illustrating a front surface of a heat dissipation structure 301 of an electronic device 300 according to an embodiment of the disclosure.

Referring to FIGS. 6 to 9, in the electronic device 300 (e.g., the electronic device 1001, 1002, 1004, 100, or 200 of FIGS. 1 to 5), the supporting member 311 (e.g., the first supporting member 211 of FIG. 4 or 5) (and/or the side structure 310 (e.g., the side structure 210 of FIG. 4 or 5)) may be provided as a portion of the heat dissipation structure 301. For example, the electronic device 300 and/or the heat dissipation structure 301 may include, or comprise, a supporting member 311 and a heat dissipation member 320 provided in a housing (e.g., the housings 110 and 201 of FIGS. 2 to 5). In an embodiment, the heat dissipation member 320 may include, or comprise, a chamber portion 321 and a flange portion 323 provided on at least a portion of an edge of the chamber portion 321, and as the flange portion 323 is welded (e.g. to form a weld) onto the supporting member 311, the heat dissipation member 320 may be stably fixed to the supporting member 311. That is, the flange portion 323 may extend outward (or project) from an edge (at least one edge) of the chamber portion 321, so as to form, or provide, a brim or lip, of (in respect of) the chamber portion 321.

In some examples, the heat dissipation member 320 may be fixed to the supporting member 311 by a bonding material (or a bonding member) such as a double-sided tape. In some examples described herein, by being fixed (attached, or secured) by welding (e.g. by welding the flange portion 323 of the heat dissipation member 320 to the supporting member 311 to form a weld), the heat dissipation member 320 and the supporting member 311 may be more firmly fixed (attached, secured, or supported), and heat absorbed by the heat dissipation member 320 may be rapidly transferred or diffused to the supporting member 311. For example, when the heat dissipation member 320 is fixed to the supporting member 311 by welding, a local temperature rise may be suppressed inside the electronic device 300, and the heat generated from a component such as the integrated circuit chip 331 may be dispersed or discharged in a wider area.

According to an embodiment, the supporting member 311 (e.g., the first supporting member 211 of FIG. 4 or FIG. 5) may have a substantially flat plate shape, and may be at least partially disposed in a space between the first surface (or front surface) 110A of FIG. 2 or the second surface (or rear surface) 110B of FIG. 3. In an embodiment, in an area or space facing the second surface 110B, the supporting member 311 may include a dividing wall(s) 319 protruding from one surface (e.g., a surface facing in the -Z direction). The dividing wall(s) 319 may divide, e.g., a space between the supporting member 311 and the second surface 110B into a plurality of (e.g., two or three or more) spaces. Two spaces in contact with one dividing wall(s) 319 may be disposed parallel to their respective sides while being substantially parallel to the XY plane.

In the illustrated embodiment, two dividing walls 319 are provided, and the first space 311a on the right side along the Y-axis direction of FIG. 6 may substantially accommodate the printed circuit board 240 and/or the camera assembly 207 of FIG. 4 or 5. The second space 311b disposed in the middle in the Y-axis direction of FIG. 6 may substantially accommodate the battery 250 of FIG. 4 or 5, and the third space 311c disposed on the left side in the Y-axis direction of FIG. 6 may be a space corresponding to the lower supporting member 260a of FIG. 4 or 5. For example, the third space 311c may accommodate electrical/electronic components such as a speaker module and an interface (e.g., a USB connector, an SD card/MMC connector, a SIM card connector, or an audio connector).

According to an embodiment, although the reference numerals in the drawings are not partially assigned, the supporting member 311 may provide a plurality of through areas penetrating two opposite surfaces. The through area indicated by "313a" may visually expose, e.g., a portion (e.g., the chamber portion 321) of the heat dissipation member 320 to an area or space in the -Z direction with respect to the supporting member 311 when the heat dissipation member 320 is disposed on the supporting member 311 on a surface facing in the +Z direction. In an embodiment, the through area indicated by "313a" may be provided as a space for accommodating a portion of the heat dissipation member 320, and may be referred to below as an accommodating (accommodation) part, and may termed as an "accommodating hole 313a (or an accommodating recess)". For example, when the printed circuit board 240 or the integrated circuit chip 331 is disposed in the first space indicated by "311a", a portion of the heat dissipation member 320 disposed in the accommodating hole 313a may absorb or move heat in the first space 311a. Here, the term 'heat in the first space 311a' may refer to heat generated by a component such as the integrated circuit chip 331 while the electronic device 300 operates.

According to an embodiment, the through areas assigned no reference numerals may provide an optical path of an optical component such as the camera assembly 207, and may be ones for disposing components such as the integrated circuit chip 331 or the battery 250 accommodated therein. In an embodiment, the through areas may be omitted, and recess(es) may be formed in at least one surface of the supporting member 311 to provide a space for disposing the components. For example, the through areas shown are only for illustrative purposes, and the embodiment(s) of the disclosure may not be limited thereto. In providing a space for disposing (or accommodating) various components, recess(es) or through areas may be selectively provided according to the strength of the supporting member 311 and/or the electronic device 300, the size and position of the components.

According to an embodiment, the supporting member 311 and/or the electronic device 300 may include, or comprise, an accommodating part, such as an accommodating hole 313a (or an accommodating recess) for accommodating (e.g. receiving, or disposing) a portion (e.g., the chamber portion 321) of the heat dissipation member 320, and a seating recess 313b provided in the circumference of the accommodating hole 313a. That is, in some examples, the seating recess is provided, or formed, in the supporting member 311 and provided within at least a portion of an edge, or circumference, of the accommodating part. The seating recess 313b may be provided in the entire circumference, or edge, of the accommodating hole 313a in one surface (e.g., a surface facing in the +Z direction) of the supporting member 311 to form a closed curve (or shape), and the plurality of seating recesses 313b may be arranged along the circumference of the accommodating recess 313a. In an embodiment, the accommodating hole 313a may be provided as one of the aforementioned through areas by being provided to penetrate from one surface of the supporting member 311 to the other surface. In an embodiment, the accommodating hole 313a may be provided in the form of a recess that does not substantially penetrate the supporting member 311. In an embodiment, a portion of the accommodating hole 313a may be provided in a structure penetrating the supporting member 311, and the other portion of the accommodating hole 313a may be provided in the form of a recess. That is, where the terms accommodating recess, or accommodating hole, is used in the embodiments or examples described, this may refer to an accommodating part being a recessed surface of the supporting member. In some examples, the accommodating recess, or hole, may extend through (e.g. penetrate), may not extend through, or may partially extend (e.g. by means of one portion, or part, thereof) through the supporting member 311.

According to an embodiment, the seating recess 313b may be provided in the circumference (or edge) of the accommodating hole 313a in any one surface of the supporting member 311, and when the accommodating hole 313a or the accommodating recess is defined as formed to have a first depth R1, the seating recess may be formed to have a second depth R2 smaller than the first depth R1. In some examples, the seating recess may be formed from a surface of the supporting member 311 such that the second depth R2 is smaller than the first depth R1 in respect of a surface (e.g. a one, same surface) of the supporting member 311. That is, the second depth R2 of the seating recess 313b is formed in the supporting member 311 and may be formed within at least a portion of a side surface of the accommodating recess (or hole) 313a, where the accommodating recess (or hole) 313a having a formed first depth R1 from the surface of the supporting member 311, with reference to Figure. 7. In the illustrated embodiment, it may be understood that the seating recess 313b is formed in the +Z direction on the supporting member 311. Here, the "first depth R1" or the "second depth R2" may be understood as a depth measured from any one surface (e.g., the surface provided with the seating recess 313b) of the supporting member 311. When the seating recess 313b is provided in the front surface (e.g., the surface facing in the +Z direction) of the supporting member 311, it may be understood that the heat dissipation member 320 is disposed on the front surface of the supporting member 311. In an embodiment, when the seating recess 313b is provided in the rear surface (e.g., the surface facing in the -Z direction) of the supporting member 311, it may be understood that the heat dissipation member 320 is disposed on the rear surface of the supporting member 311. For example, the heat dissipation member 320 may be coupled to or assembled with the supporting member 311 on the surface where the seating recess 313b is formed.

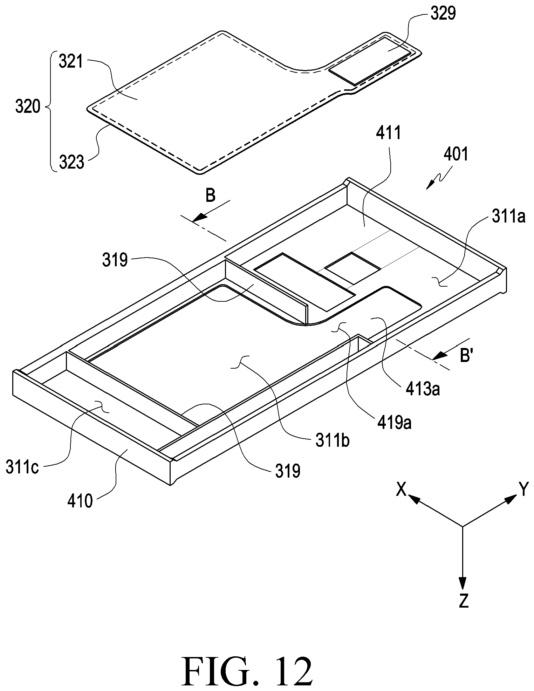

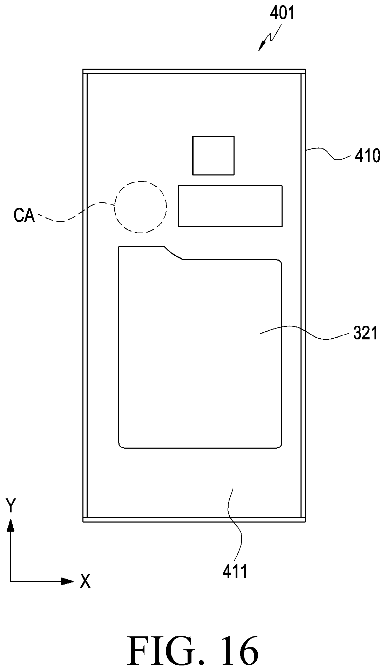

In an embodiment, the accommodating hole 313a may be provided to generally penetrate the supporting member 311, but the embodiment(s) of the disclosure are not limited thereto, and in some examples, may partially, fully, or not wholly, penetrate the supporting member 311. As mentioned above, the accommodating hole 313a and the seating recess 313b may be formed to different depths (e.g., the first depth R1 or the second depth R2) in any one surface of the supporting member 311, and at least a portion of the accommodating hole 313a may have a structure in which it is closed on the other surface of the supporting member 311. For example, in the state of being coupled to the supporting member 311, as illustrated in FIG. 12, substantially the entire shape of the heat dissipation member 320 is visually exposed to the outside of the supporting member 311 in the -Z direction, but as illustrated in FIG. 16, a portion (e.g., the portion indicated by "CA" in FIG. 16) of the heat dissipation member 320 may be concealed by the supporting member 311 in the +Z direction. The placement of the heat dissipation member 320 is described again with reference to FIGS. 12 to 16.

According to an embodiment, the heat dissipation structure 320 and/or the electronic device 300 may further include a side structure 310 provided around the supporting member 311. The side structure 310 (e.g., the side structure 210 of FIG. 4 or 5) may have, e.g., a frame shape provided to at least partially surround a space between the first surface 110A and the second surface 110B. In an embodiment, the supporting member 311 may be accommodated in a space surrounded by the side structure 310. In an embodiment, the supporting member 311 may be provided integrally with the side structure 310. For example, the supporting member 311 and the side structure 310 may be manufactured in the designed shapes through mechanical processing (e.g., computer numerical control (CNC) process) after forming, such as die casting.

According to an embodiment, when the supporting member 311 is provided integrally with the side structure 310, or when the supporting member 311 is connected with the side structure 310, the supporting member 311 and the side structure 310 may include the same material. That is, in some examples, when formed, or provided integrally, with the side structure, the supporting member 311 may be formed of, or may comprise, at least one same material. For example, the supporting member 311 (and/or the side structure 310) may include at least one metal material among copper, stainless steel, aluminum, titanium, or magnesium. In an embodiment, the supporting member 311 and the side structure 310 may receive heat from the heat dissipation member 320 and disperse the heat to another area or a wider area.

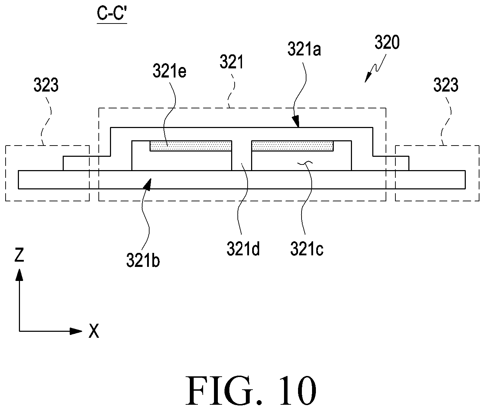

According to an embodiment, the heat dissipation member 320 may include, or comprise, e.g., a heat pipe or a vapor chamber. The configuration of the heat dissipation member 320 will be further described with reference to FIG. 10.

FIG. 10 is a cross-sectional view illustrating a heat dissipation member 320 of a heat dissipation structure 301, taken along line C-C' of FIG. 9 according to an embodiment of the disclosure.

Referring further to FIG. 10, the heat dissipation member 320 may include a chamber portion 321 and/or a flange portion 323, and the flange portion 323 may extend from at least a portion of an edge of the chamber portion 321. Herein, reference may be made to the heat dissipation member described in the preceding examples (e.g. Fig. 6). In an example, in the state illustrated in FIG. 8 or 9, it may be understood that the flange portion 323 has a closed curve shape substantially surrounding the chamber portion 321. When the heat dissipation member 320 is disposed or fixed to the supporting member 311, the flange portion 323 may be substantially welded to the supporting member 311. For example, the flange portion 323 may extend outward from an edge of the chamber portion 321 along a direction substantially parallel to one surface of the chamber portion 321. In an embodiment, the chamber portion 321 may provide an accommodating, or receiving, space 321c for accommodating a cooling medium, and may be substantially accommodated in the supporting member 311 (e.g., the accommodating hole 313a). When the chamber portion 321 is accommodated in the accommodating hole 313a, the flange portion 323 may be disposed on the seating recess 313b and may be welded to the bottom surface of the seating recess 313b by laser welding.

According to an embodiment, the heat dissipation member 320 may include a chamber member 321a forming the accommodating (receiving) space 321c and a plate member 321b coupled to face the chamber member 321a. The accommodating space 321c may be opened, or formed, on or within one surface (e.g., a surface facing in the -Z direction) of the chamber member 321a, and the plate member 321b may be coupled to the chamber member 321a so as to isolate the accommodating space 321c from the external space (e.g. the external space of the heat dissipation member).

In an embodiment, the chamber portion 321 may be substantially provided by the chamber member 321a. For example, a portion of the chamber member 321a that provides the accommodating space 321c may be provided as the chamber portion 321. That is, in some examples, the receiving space, or accommodating space, is formed within one surface of the chamber member (e.g. a surface facing in the -Z direction) by a formed recess or cavity, and may be bounded by a surface (e.g. a surface facing the +Z direction, opposite the one surface of the chamber member) of the coupled plate member. Therein is in some examples (e.g. Fig. 10), the receiving space is formed within the chamber member, and bounded by the surfaces of the chamber member and plate member, and providing the chamber portion.

In an embodiment, a portion of the plate member 321b corresponding to the accommodating space 321c may be provided as a portion of the chamber portion 321, and the edge of the plate member 321b may further extend to the outside of the chamber member 321a or may be disposed to the outside (e.g. outward) of the chamber member 321a to implement, or form, the flange portion 323. In an embodiment, a portion of the chamber member 321a provided as a structure coupled to the plate member 321b may be understood as a portion of the flange portion 323. In an embodiment, the heat dissipation member 320 (e.g., the chamber member 321a and/or the plate member 321b) may include at least one of copper, stainless steel, aluminum, titanium, or magnesium. The material of the chamber member 321a and/or the plate member 321b may be determined considering thermal conductivity or mechanical strength.

According to an embodiment, the heat dissipation member 320 may include a cooling medium accommodated in the accommodating space 321c. The cooling medium may cause a phase change by absorbing ambient heat. For example, when a portion of the heat dissipation member 320 (e.g., the chamber portion 321) is disposed adjacent to the integrated circuit chip 331 where a circuit device such as a processor (e.g., the processor 1020 of FIG. 1) is mounted, the cooling medium may be changed into a gaseous state while absorbing heat from the corresponding portion, and may be moved away from the corresponding portion to turn into a liquid state while discharging heat. For example, the cooling medium may absorb heat in the high-temperature area, discharge heat while circulating in the accommodating space 321c, and cause a phase change according to the absorption or discharge of heat. Accordingly, the heat dissipation member 320 may disperse or move locally generated heat, and may stably maintain an operating environment of a component such as the integrated circuit chip 331.

According to an embodiment, the heat dissipation member 320 may further include a wick structure 321e disposed in the accommodating space 321c. Inside the accommodating space 321c, the wick structure 321e may promote heat absorption or heat dissipation of the cooling medium by expanding the surface area of the mechanical structure that the cooling medium may contact. For example, as the wick structure 321e is disposed, heat exchange between the chamber member 321a (and/or the plate member 321b) and the cooling medium may be promoted.

According to an embodiment, the heat dissipation member 320 may be enlarged by having a fairly thin thickness (e.g., a thickness of about 1-3 mm) and having a width or length of about 2 cm or more. In a structure having a small thickness as compared with the width or length, the heat dissipation member 320 may be deformed (e.g., bending deformation) when a load is applied to a narrow area along the thickness direction (e.g., the Z-axis direction). In the bending deformation, the sealing state of the bonding portion or the accommodating space 321c between the chamber member 321a and the plate member 321b may be damaged. In an embodiment, since the heat dissipation member 320 includes at least one partition 321d disposed, or provided, in the accommodating space 321c, deformation of the heat dissipation member 320 by an external force may be suppressed. That is, the at least one partition 321d may provide support for the heat dissipation member 320. In an embodiment, the partition 321d may contact at least one of the inner surface of the chamber member 321a and/or the inner surface of the plate member 321b. In an embodiment, one end of the partition 321d may be substantially supported on the inner surface of the chamber member 321a, and the other end of the partition 321d may be supported on the inner surface of the plate member 321b. In an embodiment, when viewed in a plan view as shown in FIG. 8 or 9, the partition may have a linear trajectory XT or YT extending (or substantially extending) in the X-axis direction or the Y-axis direction. In an embodiment, when viewed in a plan view as shown in FIG. 8 or 9, the partition 321d may have a meander line trajectory MT (e.g. a winding, or curved trajectory). The extended trajectory of the partition 321d and/or the number of partitions 321d may be appropriately selected considering the phase change of the cooling medium and the smooth circulation of the cooling medium in the accommodating space 321c while securing the mechanical strength of the heat dissipation member 320.

According to an embodiment, the partition 321d may be generated in a processing process of the chamber member 321a and/or the plate member 321b. For example, in the process of forming the accommodating space 321c by etching a copper block, a structure functioning as the partition 321d may be created inside the chamber member 321a. For example, in the process of processing the chamber member 321a, a portion of the copper block may form the partition 321d. In an embodiment, when the chamber member 321a and/or the plate member 321b is manufactured by sheet metal processing a stainless steel plate, a portion of the metal plate may be bent, creating a structure that functions as the partition 321d. In an embodiment, the partition 321d may be implemented (or formed) by combining the structure created in the chamber member 321a and the structure created in the plate member 321b. When implemented by a structure on the chamber member 321a, the partition 321d may contact the plate member 321b or may be bonded to the plate member 321d by brazing or welding. When implemented by a structure on the plate member 321b, the partition 321d may contact the chamber member 321a or may be bonded to the chamber member 321a by brazing or welding. When the partition 321d is implemented by combining the structure created in the chamber member 321a and the structure created in the plate member 321b, the structure created in the chamber member 321a and the structure created in the plate member 321b may contact each other or may be bonded to each other by brazing or welding.

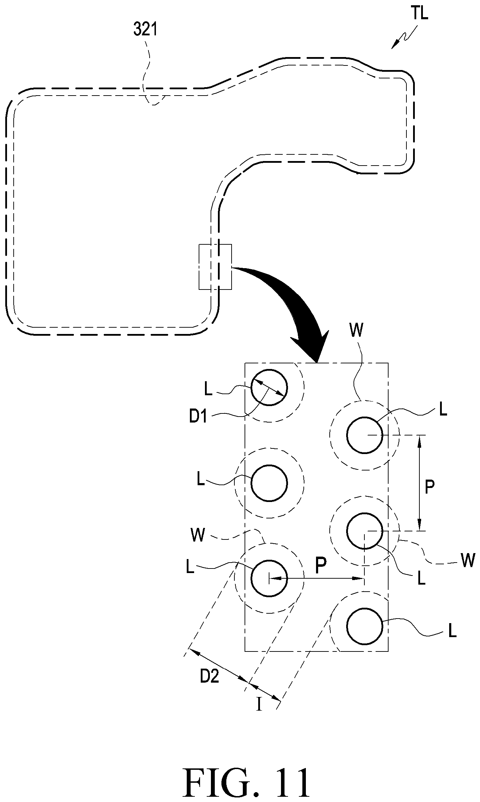

Referring back to FIGS. 6 to 9, when the heat dissipation member 320 is disposed on the supporting member 311, the chamber portion 321 may be substantially accommodated in the accommodating hole 313a, and the flange portion 323 may be disposed in the seating recess 313b. In an embodiment, the flange portion 323 may be bonded, or fixed, to the bottom surface of the seating recess 313b by welding (e.g., laser welding), so as to form a weld When laser welding is performed, at least one welding mark or bead (e.g., the welding mark W of FIG. 11) may be formed on the flange portion 323. That is, the flange portion, being welded to the seating recess 313b (e.g. a bottom surface of the seating recess), may comprise at least one welding mark (W) from the welding process, so as to form the weld. When the seating recess 313b is disposed on the front surface of the supporting member 311, the welding mark W may be visually exposed on the front surface of the supporting member 311. As is described below, the plurality of welding marks W may be disposed at (e.g. formed at, or arranged at) a designated gap between adjacent welding marks W (e.g., the gap indicated by "I" in FIG. 11), and may be arranged in at least one row along the edge of the chamber portion 321. That is, in some examples, two adjacent welding marks (e.g. within one row, and/or between rows, of the plurality of welding marks) may have a designated gap therebetween. The configuration and arrangement of the welding mark(s) W are described again with reference to FIG. 11.

According to an embodiment, at least a portion of the surface of the flange portion 323 may be disposed to form a flat surface or a curved surface substantially continuous with one surface of the chamber portion 321. In an embodiment, at least a portion of the surface of the flange portion 323 may be disposed to form a flat surface or a curved surface substantially continuous with one surface of the supporting member 311. For example, when the heat dissipation member 320 is disposed on or fixed to the supporting member 311 and is disposed on a surface (e.g., the surface facing in the +Z direction) facing the display 230, one surface of the chamber portion 321 and/or at least a portion of the surface of the flange portion 323, together with any one surface (e.g., the front surface facing in the +Z direction) of the supporting member 311, may support the display 230. As is described below, a heat dissipation sheet (e.g., the graphite sheet 239 of FIG. 7) or a protective sheet (not shown) may be disposed on the supporting member 311 on a surface facing the display 230 to support the display 230. In this case, the heat dissipation member 320 may be visually concealed from the front surface of the supporting member 311.

According to an embodiment, when disposed on the supporting member 311, as illustrated in FIG. 8 which illustrates a view from a rear surface of the device, the heat dissipation member 320 may be substantially exposed from the rear surface of the supporting member 311. The rear surface of the supporting member 311 is, e.g., a surface disposed to face the second surface 110B of the housing 201, and the printed circuit board 240 and/or the battery 250 may be disposed on the rear surface of the supporting member 311 so as to face the rear surface of the supporting member 311. In other words, at least a portion of the battery may be disposed on a same plane as the circuit board. In an example, the heat dissipation member may be arranged, located or positioned within the device such that at least a portion of the heat dissipation member (e.g. the chamber portion) is disposed corresponding to, near to, next to, the integrated circuit chip, and at least a portion (e.g. another, or second portion) is disposed corresponding to, near to, next to the battery. For example, the heat dissipation member 320 may absorb heat from a component such as the integrated circuit chip 331 disposed on the printed circuit board 240 and move or disperse the heat to a wider area. In the illustrated embodiment, "329" is a block formed of a material having high thermal conductivity such as copper (hereinafter, referred to as a "thermal conductive block 329"), and may transfer heat between the integrated circuit chip 331 and the heat dissipation member 320. For example, when the heat dissipation member 320 is not disposed close enough to the integrated circuit chip 331 due to the manufacturing specification of the supporting member 311, the thermal conductive block 329 may be disposed between the heat dissipation member 320 and the integrated circuit chip 331, thereby rapidly moving heat from the integrated circuit chip 331 to the heat dissipation member 320. In a structure in which the heat dissipation member 320 is disposed close enough to or substantially in contact with the integrated circuit chip 331, the thermal conductive block 329 may be omitted.

According to an embodiment, the thermal conductive block 329 may be attached to the heat dissipation member 320 by soldering. In an embodiment, in a structure in which the chamber member 321a (and/or the plate member 321b) is manufactured by etching a copper block, a portion of the copper block is removed by etching or laser etching on a surface on which the thermal conductive block 329 is to be disposed, so that the thermal conductive block 329 may be formed substantially integrally on the surface of the chamber member 321a (and/or the plate member 321b).

According to an embodiment, the integrated circuit chip 331 may be provided with an electromagnetically isolated environment by being disposed inside the shield can 249. In an embodiment, as the shield can 249 is disposed in the heat transfer path to the heat dissipation member 320 through the integrated circuit chip 331, the heat transfer efficiency may be reduced. In an embodiment, the electronic device 300 and/or the heat dissipation structure 301 may further include a thermal interface material (TIM) 333 protruding to the outside of the integrated circuit chip 331 while contacting the integrated circuit chip 331 inside the shield can 249. The thermal interface material 333 may be manufactured, e.g., by coating or plating a metal material on a nanofoam. The thermal interface material 333 may be configured to transfer heat between the integrated circuit chip 331 and the heat dissipation member 320 by contacting another structure, e.g., the shielding sheet 335, the thermal conductive block 329, and/or the heat dissipation member 320, outside the shield can 249. The shielding sheet 335 may suppress degradation of electromagnetic shielding performance, e.g., when the shield can 249 is partially opened in a structure in which the thermal interface material 333 is disposed.

According to an embodiment, in the illustrated embodiment, at least one of the thermal interface material 333, the shielding sheet 335, and/or the thermal conductive block 329 may be omitted. For example, according to electromagnetic shielding performance, heat transfer efficiency between the integrated circuit chip 331 and the heat dissipation member 320, and/or manufacturing specifications of a mechanical structure such as the supporting member 311, at least one of the thermal interface material 333, the shielding sheet 335, and/or the thermal conductive block 329 may be omitted, or any one selected from among the thermal interface material 333, the shielding sheet 335, and/or the thermal conductive block 329 may replace at least a portion of another.

According to an embodiment, when disposed on the supporting member 311, as illustrated in FIG. 9, which illustrates a view from a front surface of the device, the heat dissipation member 320 may be substantially concealed from the front surface of the supporting member 311. In the illustrated embodiment, it may be understood that after the heat dissipation member 320 is disposed on the front surface of the supporting member 311, the graphite sheet 239 or a protective sheet not illustrated is disposed, thereby concealing the heat dissipation member 320. The graphite sheet 239 and/or the protective sheet may be disposed between the supporting member 311 and the display 230, thereby providing an environment in which the display 230 may be disposed in a flat state even if there is a bend due to a mechanical structure or shape on the front surface of the supporting member 311. When the graphite sheet 239 is disposed between the supporting member 311 and the display 230, the graphite sheet 239 may absorb heat from the heat dissipation member 320 and/or the display 230 and move or disperse the heat to another area. For example, heat may be dispersed through the graphite sheet 239 from an area adjacent to a portion where the thermal conductive block 329 is disposed to the remaining area.

FIG. 11 is a view illustrating a welding trajectory TL or a welding mark(s) W for a heat dissipation member (e.g., the heat dissipation member 320 of FIG. 6 or 10) according to an embodiment of the disclosure.

As described above, the heat dissipation member 320 may be disposed or fixed to the supporting member 311 by laser welding. Referring to FIG. 11, laser welding may be performed, e.g., by radiating a laser beam while moving along a trajectory of a designated shape at least one designated point or area. For example, in a state of being disposed or fixed to the supporting member 311, the heat dissipation member 320 and/or the flange portion 323 may include at least one welding mark W, e.g. forming a weld. In the illustrated embodiment, welding may be intended for bonding the flange portion 323 of the heat dissipation member 320 to the supporting member 311, and may be performed at a plurality of points along the circumference (or edge) of the chamber portion 321. For example, the heat dissipation member 320 and/or the flange portion 323 may include a plurality of welding marks W arranged along the circumference of the chamber portion 321 (e.g., along a designated trajectory TL) in a state of being disposed or fixed to the supporting member 311. That is, in some examples, by welding the flange portion 323 to the supporting member 311 to form a weld, at least some of the plurality of welding marks W may be arranged on the flange portion 323 at positions along, or adjacent to, the circumference (edge) of the chamber portion 321. In an embodiment, when a plurality of welding marks W are formed, the welding marks W may be arranged in one row or may be arranged to form two or more rows. In the illustrated embodiment, a configuration in which the welding marks W are arranged in two rows is illustrated. For example, one row of the plurality of welding marks, W, may be arranged on the flange portion 323 adjacent, or along, the circumference of the chamber portion, and a second row of the plurality of welding marks may be spaced (or arranged) so that a welding mark W of the first row and a welding mark of the second row have a designated gap, I, therebetween. However, the embodiment(s) of the disclosure are not limited thereto, and the number of rows formed by the welding marks W may be greater than that the number exemplified according to the size of the flange portion 323 allowed in the electronic device 300 or the bonding force between the heat dissipation member 320 and the supporting member 311. In an embodiment, the welding marks W may be disposed at arbitrary positions and gaps with respect to each other.

According to an embodiment, the circle illustrated by solid line in FIG. 11 illustrates a trajectory in which the center of the laser beam moves (hereinafter, referred to as a "drawing pattern L"), and the circle illustrated by dashed line illustrates a shape of a welding mark W formed when the laser beam is radiated while moving along the drawing pattern L. In FIG. 11, the drawing pattern L or the welding mark W is generally illustrated in a circular shape, but the embodiment(s) of the disclosure may not be limited thereto. As is described below, the drawing pattern may be intended for suppressing the concentration of the power of the laser beam in a narrow area in laser welding, and may be implemented in various forms such as a polygonal shape, a meandering shape, or a swirl pattern.

Conventionally, when the laser beam is radiated at a fixed point by spot welding, it may be difficult to secure a sufficient bonding area or sufficient bonding force. For example, since energy is generally concentrated at the center of the laser beam and relatively low energy is distributed at the edge of the laser beam, a perforation may be formed in the welding object (e.g., the flange portion and/or the supporting member) at the center portion of the laser beam while sufficient bonding force is secured at the edge of the laser beam through spot welding. For example, when the heat dissipation member 320 is bonded to the supporting member 311 in a spot welding manner, the bonding area (e.g., the size or diameter D2 of the welding mark W) may be reduced due to perforation, or the mechanical strength of the heat dissipation member 320 (and/or the supporting member 311) may be reduced, and when no perforation is formed, sufficient bonding may not be performed at the edge portion of the laser beam.

According to an embodiment, by welding the heat dissipation member 320 to the supporting member 311 while moving the center of the laser beam along the drawing pattern L, it is possible to alleviate the concentration of energy of the laser beam at one point and to secure a bonding area larger than that achievable by the spot welding method. Although there may be some differences depending on the material or manufacturing specifications (e.g., the thickness of the flange portion 323) of the heat dissipation member 320 and/or the supporting member 311, in the illustrated embodiment, the diameter D1 of the drawing pattern L may be about 0.1-0.25 mm, and the gap P (e.g. a defined gap, or distance, between drawing pattern(s) L) between the drawing patterns L may be about 0.2-0.5 mm. The laser beam may have a power of about 100-350W, and weld the heat dissipation member 320 to the supporting member 311 while moving along the drawing pattern L at a speed of about 600-1000mm/s. When the size (e.g., diameter D1) or arrangement of the drawing pattern L and/or the irradiation conditions of the laser beam are met, the welding mark W may have a diameter of about 0.2 to 0.4 mm. In an embodiment, when a plurality of welding marks W are formed, a gap I (e.g. a designated gap between the welding marks) of about 0.045 to 0.155 mm may be formed between two adjacent welding marks W. For example, when a plurality of welding marks W are formed, an appropriate gap I may be provided between two adjacent welding marks W by adjusting the distance P (e.g. the defined distance, or gap) of the drawing pattern L or the power of the laser beam. In some examples, the appropriate gap (e.g. the designated gap, such as I, between the welding marks) may be formed, or set, by adjusting or setting the distance P of the drawing pattern for performing welding process.

According to an embodiment, when the power of the laser beam increases, the energy concentrated on the central portion of the beam may increase. Thus, it is possible to suppress generation of a perforation by setting the diameter D1 of the drawing pattern L to be larger. Although it may vary depending on a combination of the power of the laser beam and the diameter D1 of the drawing pattern P, the diameter D2 of the welding mark W may be generally proportional to the size (e.g., the diameter D1) of the drawing pattern L. In an embodiment, when a laser beam of about 200 W power is radiated along the drawing pattern L having a diameter of about 0.2 mm D1, the welding mark W may have a diameter D2 of about 0.34-0.36 mm. In an embodiment, when a laser beam of about 150 W power is radiated along the drawing pattern L having a diameter of about 0.15 mm D1, the welding mark W may have a diameter D2 of about 0.24-0.26 mm. These example values may be ones measured after welding the flange portion 323, which is formed of stainless steel and has a thickness of about 0.04-0.1 mm, to the supporting member 311 while moving the laser beam along the drawing pattern(s) L disposed at a gap P of about 0.4 mm at a speed of about 800 mm/s, and it is noted that the above-mentioned values do not limit the embodiment(s) and examples of the disclosure as described above.

As such, in the electronic device 300 and/or the heat dissipation structure 301 according to an embodiment(s) of the disclosure, the welding mark(s) W may have a larger bonding area than when spot welding is performed, even if a laser beam of the same power is radiated. For example, as the welding mark W is formed while the power of the laser beam is distributed or dispersed in a wider area, it is possible to stably fix the heat dissipation member 320 while suppressing generation of a perforation.

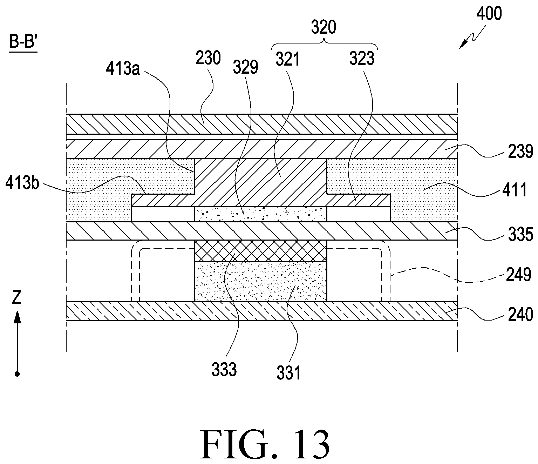

FIG. 12 is a view illustrating a heat dissipation structure 401 of an electronic device (e.g., the electronic device 1001, 1002, 1004, 100, or 200 of FIGS. 1 to 5) according to an embodiment of the disclosure. FIG. 13 is a view illustrating a heat dissipation structure 401 of an electronic device 400, cut along line B-B' of FIG. 12 according to an embodiment of the disclosure.

As compared with the heat dissipation structure 301 of FIGS. 6 and 7, the heat dissipation structure 401 of FIGS. 12 and 13 may differ in that the heat dissipation member 320 is disposed or assembled on the supporting member 411 on the surface facing in the -Z direction. In describing the heat dissipation structure 401 of FIGS. 12 and 13, the components which may easily be appreciated through the previous embodiments are denoted with or without the same reference numerals and their detailed description may be skipped. The electronic device 400 including the heat dissipation structure 401 of FIGS. 12 and 13 may be at least partially the same as, e.g., the electronic devices 1001, 1002, 1004, 100, and 200 of FIGS. 1 to 5, where reference may be made to the same components as described therein, as is relevant.

Referring to FIGS. 12 and 13, the accommodating part, such as an accommodating hole 413a (or accommodating recess) may be formed to substantially penetrate the supporting member 411, and the seating recess 413b may be provided in (e.g. formed in) one surface of the supporting member 411, e.g., the surface facing in the -Z direction. In an embodiment, the seating recess 413b may be generally provided in at least a portion of the circumference, or edge, of the accommodating hole 413a. That is, in some examples, the seating recess 413b is provided, or formed, in the supporting member 411 and provided in at least a portion of the edge, or circumference, of the accommodating part. Considering the coupling force between the heat dissipation member 320 and the supporting member 411, the seating recess 413b for welding may be provided in a closed curve shape substantially surrounding the accommodating hole 413a. However, the shape of the accommodating part, such as the accommodating hole, or recess, 413a is not limited as such, and the seating recess 413b may be provided in any shape within a circumference of the accommodating hole 413a, or recess, and substantially surrounding the accommodating hole or recess 413a. When the thermal conductive material is included, the supporting member 411 may function as a heat dissipation structure for moving or dispersing heat from the heat dissipation member 320 to another area. When being integrally formed with the supporting member 411 and including a thermal conductive material, the side structure 410 may function as a heat dissipation structure that discharges heat from the heat dissipation member 320 and/or the supporting member 411 to the external space.

According to an embodiment, the dividing wall(s) 319 may be provided on any one surface of the supporting member 411, e.g., the surface facing in the -Z direction, and when the heat dissipation member 320 is disposed to cross a portion of the dividing wall(s) 319, a portion of the dividing wall 319 may be removed to provide an avoidance area 419a (or assembly space). For example, when the heat dissipation member 320 is disposed on one surface of the supporting member 411, the heat dissipation member 320 may be disposed at a position substantially contacting the supporting member 411 via the avoidance area 419a. The heat dissipation member 320, e.g., a portion of the chamber portion 321, may be aligned with the integrated circuit chip 331 substantially in the Z-axis direction, and the thermal conductive block 329 and/or the thermal interface material 333 may be provided to transfer heat between the integrated circuit chip 331 and the heat dissipation member 320. For example, heat generated from the integrated circuit chip 331 may be transferred to the chamber portion 321 in the +Z direction via the thermal interface material 333 and the thermal conductive block 329. The configuration of the shield can 249, the shielding sheet 335, the graphite sheet 239, and/or the display 230 may be similar to the configuration of the electronic device 400 of FIG. 7, and thus a detailed description thereof will be omitted. The configuration in which the heat dissipation member 320 and/or the flange portion 323 is welded to the bottom surface of the seating recess 413b may be similar to the configuration of FIG. 7 and/or FIG. 11.

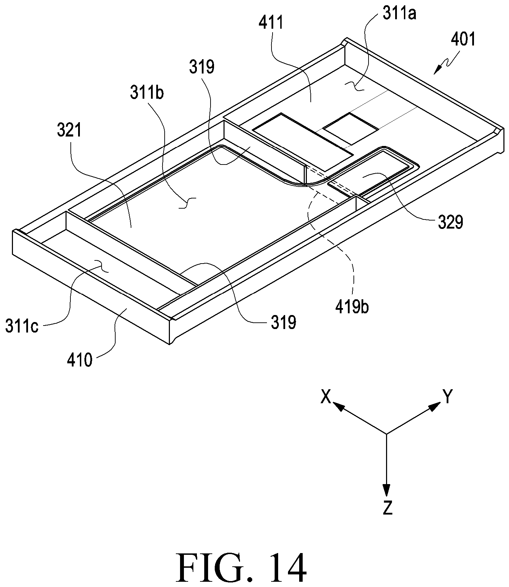

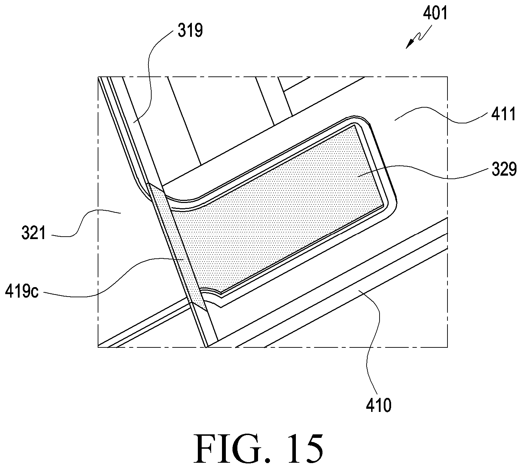

In an embodiment, the electronic device 400 and/or the heat dissipation structure 401 may further include a reinforcing member (e.g., the reinforcing plate 419b of FIG. 14), thereby suppressing a decrease in strength of the supporting member 411 that may occur due to the avoidance area 419a. For example, the reinforcing member (e.g., the reinforcing plate 419b of FIG. 14) may be disposed in the avoidance area 419a after being disposed or fixed to the supporting member 411, thereby supplementing mechanical strength in the removed portion of the dividing wall(s) 319. In an embodiment, the reinforcing member (e.g., the reinforcing plate 419b of FIG. 14) may support the heat dissipation member 320 in the +Z direction, and the supporting member 411 may support the heat dissipation member 320 (e.g., the flange portion 323) in the -Z direction. For example, when the reinforcing member (e.g., the reinforcing plate 419b of FIG. 14) is disposed, the heat dissipation member 320 may be fixed between the reinforcing member (e.g., the reinforcing plate 419b of FIG. 14) and the supporting member 411. The configuration of such a reinforcing member will be further described with reference to FIGS. 14 and 15.

FIG. 14 is a view illustrating a reinforcing structure of a supporting member 411 in a heat dissipation structure (e.g., the heat dissipation structure 401 of FIG. 12) according to an embodiment of the disclosure. FIG. 15 is a view illustrating a reinforcing structure of a supporting member 411 in a heat dissipation structure 401 according to an embodiment of the disclosure.

First, referring to FIG. 14, the electronic device (e.g., the electronic device 400 of FIG. 13), the heat dissipation structure 401, and/or the supporting member 411 may further include a reinforcing plate 419b provided as a reinforcing structure. The reinforcing plate 419b may be substantially formed of the same material as the dividing wall 319 and/or the supporting member 411, and may function as a structure that substantially fills the removed portion (e.g., the avoidance area 419a) of the dividing wall 319 when disposed on the supporting member 411. For example, as the reinforcing plate 419b is disposed, the dividing wall 319 may be implemented to be disposed on the entire width (e.g., the length measured along the X-axis direction) of the supporting member 411, similar to the embodiment of FIG. 6 or 8. Although not illustrated, the dividing wall 319 may be substantially omitted from the supporting member 411 before the heat dissipation member 320 and/or the reinforcement plate 419b is disposed. For example, after the heat dissipation member 320 is disposed or fixed to the supporting member 411, a reinforcing plate having a length corresponding to the entire width (e.g., the length measured along the X-axis direction) of the supporting member 411 may be disposed, thereby dividing the space between the supporting member 411 and the second surface (e.g., the second surface 110B of FIG. 3) into a plurality of spaces. For example, the dividing wall 319 may be implemented as the reinforcing plate itself.

Referring to FIG. 15, the reinforcing plate 419c provided in the avoidance area 419a may be implemented by a portion of the thermal conductive block 329. For example, the reinforcing plate 419c may be implemented by bending a portion of the thermal conductive block 329 or extending a portion of the thermal conductive block 329 to the inside of the avoidance area (e.g., the avoidance area 419a of FIG. 12), thereby functioning as a reinforcing structure of the supporting member 411 and/or the dividing wall 319. Although not illustrated, when the heat dissipation member 320 (e.g., the plate member 321b of FIG. 10) is manufactured by sheet metal processing, a portion of the plate member 321b may be bent to implement a structure corresponding to the reinforcing plate 419c or the dividing wall 319. For example, the dividing wall 319 of FIG. 14 or 15 is not substantially provided in the supporting member 411, and the dividing wall may be implemented on the supporting member 411 by the shape of the heat dissipation member 320 (e.g., the plate member 321b). When the dividing wall is implemented by the shape of the plate member 321b, a portion (e.g., a portion functioning as the dividing wall) of the plate member 321b may be welded to an inner wall of the side structure 410 or one surface (e.g., the surface facing in the -Z direction) of the supporting member 411.

FIG. 16 is a view illustrating a front surface of a heat dissipation structure (e.g., the heat dissipation structure 401 of FIG. 12) of an electronic device (e.g., the electronic devices 1001, 1002, 1004, 100, and 200 of FIGS. 1 to 5) according to an embodiment.

Referring further to FIG. 16 together with FIG. 12, it may be understood that the heat dissipation member 320 (e.g., the chamber portion 321) is disposed in at least a portion of the first space 3 11a, the second space 3 11b, and/or the third space 311c when disposed in the supporting member 411 on the surface facing in the -Z direction. For example, the heat dissipation member 320 may be at least partially accommodated in substantially the same space as the printed circuit board 240 and/or the battery 250 of FIG. 5. In an embodiment, it may be understood that a portion of the heat dissipation member 320 (e.g., the chamber portion 321) is disposed at a position substantially corresponding to the integrated circuit chip 331 of FIG. 13, and another portion of the heat dissipation member 320 (e.g., the chamber portion 321) is disposed corresponding to the battery 250. Here, "the heat dissipation member 320 is partially disposed at a position corresponding to the integrated circuit chip 331" may be understood as the integrated circuit chip 331 being disposed on the printed circuit board 240 and facing toward the supporting member 411, and wherein the heat dissipation member 320 comprises at least a portion thereof at a position or space substantially corresponding to the integrated circuit chip. In an embodiment, it may be understood that at least a portion of the battery 250 is disposed on, the same plane as the printed circuit board 240 and/or the integrated circuit chip 331, and it may be understood that the battery 250, the printed circuit board 240, and/or the integrated circuit chip 331 are disposed on a plane substantially parallel to the heat dissipation member 320. Herein, in some examples, a plane may be considered in one or more directions, or axes, in respect of the electronic device, and the at least a portion of the battery and/or at least a portion of the integrated circuit chip may be aligned, and/or substantially aligned, in the plane, direction and/or axis.

According to an embodiment, when the heat dissipation member 320 is disposed on the supporting member 411 on the surface facing in the -Z direction, it may be understood that the heat dissipation member 320 defines at least a portion of the first space 311a, the second space 311b, and/or the third space 311c. For example, it may be understood that at least a portion of the inner wall, floor, or ceiling of the first space 311a, the second space 311b, and/or the third space 311c is formed by the heat dissipation member 320. Accordingly, the heat dissipation member 320 may at least partially absorb or move heat in the first space 311a, the second space 311b, and/or the third space 311c, thereby suppressing a local temperature rise in the electronic device 400 and stabilizing the operating environment of various components.

According to an embodiment, when the heat dissipation member 320 (e.g., the chamber portion 321) is disposed in the supporting member 411 on the surface facing in the -Z direction, a portion of the accommodating hole 413a may be implemented in the form of a through hole, and another portion of the accommodating hole 413a may be implemented in the form of a recess. For example, the accommodating hole 413a may be implemented in the form of a recess in a portion (e.g., the portion indicated by "CA") corresponding to the first space 311a, and may be implemented in the form of a through area in an area corresponding to the second space 311b. As the number of through structures such as the accommodating hole 413a increases and/or the size of the through area increases, the strength of the supporting member 411 may decrease. The heat dissipation member 320 may be disposed at least partially in the space (e.g., the first space 311a) in which the integrated circuit chip 331 is disposed to absorb the heat generated by the integrated circuit chip 331 and, in the corresponding portion, the accommodating hole 413a may be implemented in the form of a recess, rather than a through structure, thereby reducing the size of the through area. For example, in disposing the heat dissipation member 320, the accommodating hole 413a may be partially implemented in the form of a recess, thereby reducing the reduction in the strength of the supporting member 411.

In an embodiment, the structure of the accommodating hole 413a of FIG. 16 may be selectively combined with the reinforcing plate 419b or 419c of the embodiment(s) described with reference to FIG. 14 or 15. For example, the heat dissipation member 320 may be disposed on one surface (e.g., the surface facing in the -Z direction) of the supporting member 411, and heat dissipation performance and mechanical strength may be secured.

An electronic device (e.g., the electronic device 1001, 1002, 1004, 100, 200, 300, or 400 of FIGS. 1, 5, 7, and/or 13) according to an embodiment(s) of the disclosure may rapidly move, disperse, or discharge the heat generated from an internal component such as an integrated circuit chip (e.g., the integrated circuit chip 331 of FIG. 7 and/or 13) using a heat dissipation member (e.g., the heat dissipation member 320 of FIG. 6, 7, 12, and/or 13). In an embodiment, as a bonding structure such as welding applies in disposing the heat dissipation member, a sufficient coupling force may be secured between the supporting member (e.g., the first supporting member 211 of FIG. 4 and/or FIG. 5, or the supporting member 311 or 411 of FIG. 6, 7, 12, and/or 13) and the heat dissipation member, and even if the size of the heat dissipation member increases, the strength of the supporting member and/or the electronic device may be sufficiently secured. For example, since the size or area of the heat dissipation member may be sufficiently secured in the electronic device, heat generated in the electronic device may be discharged more quickly. Accordingly, even if heat generating components are disposed inside, the electronic device may provide an environment in which various electronic components may operate stably.

Effects of the disclosure are not limited to the foregoing, and other unmentioned effects would be apparent to one of ordinary skill in the art from the description of the foregoing embodiment(s).

As described above, an electronic device (e.g., the electronic device 1001, 1002, 1004, 100, 200, 300, or 400 of FIGS. 1 to 5, FIG. 7, and/or FIG. 13) comprises a housing (e.g., the housing 110 or 201 of FIGS. 2 to 5) including a first surface (e.g., the first surface 110A of FIG. 2) and a second surface (e.g., the second surface 110B of FIG. 3) facing in a direction opposite to the first surface, a supporting member (e.g., the first supporting member 211 of FIG. 4 and/or FIG. 5, or the supporting member 311 or 411 of FIG. 6, FIG. 7, FIG. 12, and/or FIG. 13) accommodated in the housing between the first surface and the second surface, the supporting member including an accommodating recess or an accommodating hole (e.g., the accommodating hole 313a or 413a of FIG. 7 and/or FIG. 13) formed to a first depth from one of two opposite surfaces and a seating recess (e.g., the seating recess 313b or 413b of FIG. 7 and/or FIG. 13) provided in at least a portion of a circumference of the accommodating recess or the accommodating hole in any one surface of the supporting member, and a heat dissipation member (e.g., the heat dissipation member 320 of FIG. 6, FIG. 7, FIG. 12, and/or FIG. 13) including a chamber portion (e.g., the chamber portion 321 of FIG. 6, FIG. 7, FIG. 12, and/or FIG. 13) at least partially accommodated in the accommodating recess or the accommodating hole and at least one flange portion (e.g., the flange portion 323 of FIG. 6, FIG. 7, FIG. 12, and/or FIG. 13) extending from at least a portion of an edge of the chamber portion and welded to a bottom surface of the seating recess. In an embodiment, the seating recess is recessed to a second depth smaller than the first depth from any one surface of the supporting member.

According to an embodiment, the electronic device may further comprise at least one welding mark (e.g., the welding mark W of FIG. 11) formed on the flange portion.

According to an embodiment, the welding mark may have a circular or polygonal shape with a diameter or a diagonal length of 0.2mm or more and 0.4mm or less.

According to an embodiment, the electronic device may further comprise a plurality of welding marks formed on the flange portion. In an embodiment, the welding marks may be arranged in at least one row along a circumference of the chamber portion.

According to an embodiment, a gap between two adjacent welding marks of the welding marks may be 0.045mm or more and 0.155mm or less.

According to an embodiment, at least a portion of a surface of the flange portion may be disposed to form a continuous flat surface or a continuous curved surface with any one surface of the chamber portion.

According to an embodiment, at least a portion of the flange portion may be disposed to form a continuous flat surface or a continuous curved surface with any one surface of the supporting member.

According to an embodiment, the electronic device may further comprise a side structure (e.g., the side structure 210, 310, or 410 of FIG. 4, FIG. 5, FIG. 6, and/or FIG. 12) provided to at least partially surround a space between the first surface and the second surface. In an embodiment, the supporting member may include the same material as the side structure and be integrally formed with the side structure.

According to an embodiment, the supporting member or the heat dissipation member may include at least one of copper, stainless steel, aluminum, titanium, or magnesium.

According to an embodiment, the heat dissipation member may further include a chamber member (e.g., the chamber member 321a of FIG. 10) providing the chamber portion by forming an receiving space (e.g., the receiving space 321c of FIG. 10) opened in one surface of the chamber member and a plate member (e.g., the plate member 321b of FIG. 10) coupled to face the chamber member to isolate the receiving space from an external space. According to an embodiment, the flange portion may be provided as an edge of the plate member extends or is disposed outward of the chamber member.

According to an embodiment, the heat dissipation member may further include at least one partition (e.g., the partition 321d of FIG. 10) provided in the receiving space and configured to contact or be supported by at least one of an inner surface of the chamber member and the plate member.

According to an embodiment, the electronic device may further comprise a circuit board (e.g., the printed circuit board 240 of FIG. 4 or 5 and/or the circuit board 240 of FIG. 7 or FIG. 13) disposed between the second surface and the supporting member and including an integrated circuit chip (e.g., the integrated circuit chip 331 of FIG. 6 and/or FIG. 12) mounted on a surface facing the supporting member and a battery (e.g., the battery 250 of FIG. 4 or FIG. 5) at least partially disposed between the second surface and the supporting member and including at least a portion disposed on the same plane as the circuit board. In an embodiment, a portion of the chamber portion may be disposed corresponding to the integrated circuit chip, and another portion of the chamber portion is disposed corresponding to the battery.

According to an embodiment, the electronic device may further comprise a thermal interface material (TIM) (e.g., the thermal interface material 333 of FIG. 7 or FIG. 13) provided between the integrated circuit chip and the heat dissipation member. In an embodiment, the thermal interface material may be configured to transfer heat between the integrated circuit chip and the heat dissipation member.

According to an embodiment, the electronic device may further comprise a heat conductive block (e.g., the heat conductive block 329 of FIG. 7 or FIG. 13) provided between the integrated circuit chip and the heat dissipation member. In an embodiment, the heat conductive block may be configured to transfer heat between the integrated circuit chip and the heat dissipation member.

According to an embodiment, the electronic device may further comprise a display (e.g., the display 230 of FIG. 4, FIG. 5, FIG. 7, and/or FIG. 13) disposed between the first surface and the supporting member and a graphite sheet (e.g., the graphite sheet 239 of FIG. 7 and/or FIG. 13) disposed between the display and the supporting member. In an embodiment, the graphite sheet may be configured to absorb heat from the display or the heat dissipation member and move or disperse the heat to another area.

According to an embodiment of the disclosure, an electronic device (e.g., the electronic device 1001, 1002, 1004, 100, 200, 300, or 400 of FIGS. 1 to 5, FIG. 7, and/or FIG. 13) comprises a housing (e.g., the housing 110 or 201 of FIGS. 2 to 5), a supporting member (e.g., the first side member 211 of FIG. 4 and/or FIG. 5 or the supporting member 311 or 411 of FIG. 6, FIG. 7, FIG. 12, and/or FIG. 13) accommodated in the housing, the supporting member including an accommodating recess or an accommodating hole (e.g., the accommodating hole 311a or 413a of FIG. 7 and/or FIG. 13) provided in at least one surface and a seating recess (e.g., the seating recess 311b or 413b of FIG. 7 and/or FIG. 13) provided in at least a portion of a circumference of the accommodating recess or the accommodating hole in any one surface of the supporting member, a heat dissipation member (e.g., the heat dissipation member 320 of FIG. 6, FIG. 7, FIG. 12, and/or FIG. 13) including a chamber portion (e.g., the chamber portion 321 of FIG. 6, FIG. 7, FIG. 12, and/or FIG. 13) at least partially accommodated in the accommodating recess or the accommodating hole and at least one flange portion (e.g., the flange portion 323 of FIG. 6, FIG. 7, FIG. 12, and/or FIG. 13) extending from at least a portion of an edge of the chamber portion and welded to a bottom surface of the seating recess, and a plurality of welding marks (e.g., the welding mark W of FIG. 12) formed on the flange portion and arranged in at least one row along a circumference of the chamber portion. In an embodiment, the welding marks have a circular or polygonal shape with a diameter or a diagonal length of 0.2mm or more and 0.4mm or less. In an embodiment, a gap between two adjacent welding marks of the welding marks may be 0.045mm or more and 0.155mm or less.

According to an embodiment, the heat dissipation member may further include a chamber member (e.g., the chamber member 321a of FIG. 10) providing the chamber portion by forming an receiving space (e.g., the receiving space 321c of FIG. 10) opened in one surface of the chamber member and a plate member (e.g., the plate member 321b of FIG. 10) coupled to face the chamber member to isolate the receiving space from an external space. In an embodiment, the flange portion may be provided as an edge of the plate member extends or is disposed outward of the chamber member.

According to an embodiment, the supporting member or the heat dissipation member may include at least one of copper, stainless steel, aluminum, titanium, or magnesium.

According to an embodiment, the heat dissipation member may further include at least one partition (e.g., the partition 321d of FIG. 10) provided in the receiving space and configured to contact or be supported by at least one of an inner surface of the chamber member and the plate member.

According to an embodiment, the electronic device may further comprise a circuit board (e.g., the printed circuit board 240 of FIG. 4 or FIG. 5 and/or the circuit board 240 of FIG. 7 or FIG. 13) disposed to at least partially face the supporting member and including an integrated circuit chip (e.g., the integrated circuit chip 331 of FIG. 6 and/or FIG. 12) mounted on a surface facing the supporting member, a thermal interface material (e.g., the thermal interface material 333 of FIG. 7 or FIG. 13) provided between the integrated circuit chip and the heat dissipation member and configured to transfer heat between the integrated circuit chip and the heat dissipation member, and a battery disposed to at least partially face the supporting member and including at least a portion disposed on the same plane as the circuit board. In an embodiment, a portion of the chamber portion may be disposed corresponding to the integrated circuit chip, and another portion of the chamber portion is disposed corresponding to the battery.

While the disclosure has been described and shown in connection with an embodiment thereof, it should be appreciated that an embodiment is intended as limiting the invention but as illustrative. It will be apparent to one of ordinary skill in the art that various changes may be made in form and detail without departing from the overall scope of the disclosure, including the appended claims and their equivalents.

For example, in the embodiment referring to FIG. 11, the numerical range for the diameter D1 or gap P of the drawing pattern L and/or the diameter D2 or gap I of the weld mark W are exemplified, but the embodiment(s) of the disclosure are not limited thereto. In an embodiment, the gap I between the weld marks W may be inversely proportional to the diameter D1 of the drawing pattern L and/or may be proportional to the gap P of the drawing pattern L. In an embodiment, although the diameter D1 or gap P of the drawing pattern L is designed to be the same, when the laser output upon welding increases, the gap I between two adjacent welding marks W may be substantially zero (0). For example, in the illustrated embodiment, the welding marks W are arranged at designated gaps I, but the two welding marks W disposed on their sides may be substantially disposed to contact each other. In an embodiment, the welding mark W may be formed to have a closed loop trajectory along the edge of the heat dissipation member 320. In an embodiment, in at least a partial section of the closed loop trajectory, the welding mark W may include a zigzagged trajectory or a meandering trajectory.

## Claims

1. An electronic device (1001; 1002; 1004; 100; 200; 300; 400), comprising:
a housing (110; 201) including a first surface (110A) and a second surface (110B) facing in a direction opposite to the first surface;
a supporting member (211; 311; 411) accommodated in the housing between the first surface and the second surface, the supporting member comprising:
an accommodating part (313a; 413a) having a first depth from a surface of the supporting member; and
a seating recess (313b; 413b) provided in at least a portion of an edge of the accommodating part in the surface of the supporting member; and
a heat dissipation member (320) comprising:
a chamber portion (321) at least partially accommodated in the accommodating part and
a flange portion (323) extending from at least a portion of an edge of the chamber portion and the flange portion (323) welded to a bottom surface of the seating recess by a weld,
wherein the seating recess is recessed to a second depth smaller than the first depth from the surface of the supporting member.

2. The electronic device of claim 1, wherein the flange portion comprises at least one welding mark (W) corresponding to the weld of the flange portion to the bottom surface of the seating recess.

3. The electronic device of claim 2, wherein the at least one welding mark has a circular or polygonal shape with a diameter or diagonal length of between 0.2mm and 0.4mm .

4. The electronic device of claim 2, wherein the at least one welding mark comprises a plurality of welding marks,
wherein the plurality of welding marks are arranged in at least one row along the edge of the chamber portion.

5. The electronic device of claim 4, wherein two adjacent marks of the plurality of welding marks comprise a designated gap therebetween; and
wherein the designated gap is between 0.045mm and 0.155mm.

6. The electronic device of any one of claims 1 to 5, wherein at least a portion of a surface of the flange portion is disposed to form a continuous flat surface or a continuous curved surface with the chamber portion.

7. The electronic device of any one of claims 1 to 6, wherein at least a portion of the flange portion is disposed to form a continuous flat surface or a continuous curved surface with the supporting member.

8. The electronic device of any one of claims 1 to 7, further comprising a side structure (210; 310; 410) provided to at least partially surround a space between the first surface and the second surface,
wherein the supporting member is integrally formed with the side structure.

9. The electronic device of claim 8, wherein the supporting member or the heat dissipation member includes at least one of copper, stainless steel, aluminum, titanium, or magnesium.

10. The electronic device of any one of claims 1 to 9, wherein the heat dissipation member includes:
a chamber member (321a) comprising a receiving space (321c) formed within a surface of the chamber member (321a) to provide the chamber portion; and
a plate member (321b) facing the surface of the chamber member, and coupled to the chamber member (321a) to isolate the receiving space from an external space of the heat dissipation member, and
wherein an edge of the plate member extends outward of the chamber member to form the flange portion (323).

11. The electronic device of claim 10, wherein the heat dissipation member further comprises at least one partition 321d provided in the receiving space and configured to contact at least one of an inner surface of the chamber member and the plate member.

12. The electronic device of any one of claims 1 to 11, further comprising:
a circuit board (240) disposed between the second surface and the supporting member and comprising an integrated circuit chip (331) mounted on a surface of the circuit board and facing the supporting member; and
a battery (250) at least partially disposed between the second surface and the supporting member and including at least a portion disposed in a same plane as the circuit board,
wherein the heat dissipation member is arranged such that a portion of the chamber portion is disposed at a position corresponding to the integrated circuit chip, and another portion of the chamber portion is disposed at a position corresponding to the battery.

13. The electronic device of claim 12, further comprising a thermal interface material (TIM) (333) provided between the integrated circuit chip and the heat dissipation member,
wherein the thermal interface material is configured to transfer heat between the integrated circuit chip and the heat dissipation member.

14. The electronic device of claim 12 or 13, further comprising a heat conductive block (329) provided between the integrated circuit chip and the heat dissipation member,
wherein the heat conductive block is configured to transfer heat between the integrated circuit chip and the heat dissipation member.

15. The electronic device of any one of claims 1 to 14, further comprising:
a display (230) disposed between the first surface and the supporting member; and
a graphite sheet (239) disposed between the display and the supporting member,
wherein the graphite sheet is configured to absorb heat from at least one of the display or the heat dissipation member and move or disperse the heat to another area.
